# EUROPEAN PATENT APPLICATION

(11) **EP 4 832 149 A1**
(43) Date of publication of application: **28.10.2026**
(21) Application number: 24907958.3
(22) Date of filing: 10.12.2024
(51) Int. Cl.: H01M 10/54, G01R 31/52, H02J 7/00, B09B 3/40, B09B 101/16

(54) **BATTERY PROCESSING METHOD**

(30) Priority: 18.12.2023 KR 20230185232
(71) Applicant: POSCO Holdings Inc., Pohang-si, Gyeongsangbuk-do 37859 (KR)
(72) Inventor: HAN, Sangwoo, Pohang-si, Gyeongsangbuk-do 37859 (KR); PARK, Joongkil, Pohang-si, Gyeongsangbuk-do 37859 (KR); PARK, Chonglyuck, Pohang-si, Gyeongsangbuk-do 37859 (KR); KIM, Wanyi, Pohang-si, Gyeongsangbuk-do 37859 (KR); LEE, Juseung, Pohang-si, Gyeongsangbuk-do 37859 (KR); PARK, Junyong, Pohang-si, Gyeongsangbuk-do 37859 (KR)
(74) Representative: Zacco Sweden AB
(86) International application number: PCT/KR2024/020207
(87) International publication number: WO 2025/135674

(57) **Abstract**

The present invention relates to a battery treatment method. The battery treatment method of the present invention includes preparing a waste battery, measuring an average charging and discharging time of the waste battery, measuring an average charging and discharging time of a module-unit waste battery among the waste battery and comparing the same with the average charging and discharging time, and determining whether the module is a normal module according to whether the average charging and discharging time of the pack-unit waste battery and the charging and discharging time of the module-unit waste battery satisfy Equation 1 according to the present specification.

## Description

### [TECHNICAL FIELD]

The present invention relates to a waste battery, and more particularly, to a battery treatment method.

### [BACKGROUND ART]

Due to environmental issues, electric vehicles, for which demand and supply are rapidly increasing, have battery technology as a key element. Waste batteries generated from the electric vehicles have become a social issue in terms of treatment of the waste batteries. Treatment of waste batteries generated from the electric vehicles has emerged as a social issue. Lithium ion batteries are used as the waste batteries, and contain organic solvents, explosive materials, heavy metal materials such as Ni, Co, Mn, Fe, and P, carbon, and other electrolyte materials. Among these, Ni, Co, Mn, Fe, P, and Li have high rarity value as valuable metals, and recovery and recycling processes after disposal of lithium secondary batteries are emerging as an important research field.

Specifically, a lithium secondary battery mainly includes copper and aluminum used as current collectors, Li-, Ni-, Co-, and Mn-containing oxides constituting a positive electrode, and graphite constituting a negative electrode, and includes a separator separating the positive electrode and the negative electrode, and an electrolyte solution injected into the separator. As a solvent and a salt constituting the electrolyte solution, carbonate organic materials such as ethylene carbonate and propylene carbonate are mainly mixed and used, and, for example, LiPF₆ is used.

A waste battery including the lithium secondary battery has a technical issue in that it must undergo safe dismantling. The waste battery may be process scrap generated when manufacturing a battery, or may be discharged from an electric vehicle or an energy storage device after use. The waste battery exists in a cell unit, a module unit, or a pack unit, and in general, voltage is generally checked in a pack or module unit. In many cases, the waste battery is generated as a waste battery because the battery has reached the end of its life; however, in some waste batteries, the waste battery may be generated because an electrode is short-circuited.

When the waste battery is generated because an electrode is short-circuited, it is important to distinguish the same because electrical discharge is impossible. However, since one pack has a structure in which several hundreds of cells are connected in series or in parallel, it is not easy to find a short-circuited cell in a parallel structure, and thus it is difficult to perform electrical discharge.

In order to solve this problem, a water discharge method has been used, in which a waste battery is separated into cell units, an outer cover is cut, and the waste battery is immersed in water or brine and discharged. However, the water discharge method may cause various problems in a subsequent process due to sodium and chlorine in wastewater or brine.

### [DETAILED DESCRIPTION OF THE INVENTION]

### [Technical Problem]

A technical problem to be solved by the present invention is to provide a battery treatment method capable of safely discharging a battery even when the battery includes a short-circuited cell, and reducing a risk of fire when shredding the discharged battery.

### [Technical Solution]

A battery treatment method according to one embodiment of the present invention may include preparing a waste battery in a pack unit including a plurality of modules or having two or more modules, measuring charging and discharging rates of the waste battery in the pack unit including the plurality of modules or having two or more modules to measure an average charging and discharging time, measuring charging and discharging rates of a waste battery in a module unit to measure an average charging and discharging time of the waste battery in the module unit and comparing the same with the average charging and discharging time, and determining whether a module is a normal module or a defective module according to whether the average charging and discharging time of the waste battery in the pack unit and the charging and discharging time of the waste battery in the module unit satisfy the following Equation 1. <Equation 1> $\frac{\left|{t}_{aver}-{t}_{module}\right|}{{t}_{aver}} \leq \frac{1}{number cell in module}$

In Equation 1, tₐᵥₑᵣ means an average charging and discharging average time of the waste battery in a pack unit including a plurality of modules or having two or more modules / the number of waste batteries in a module unit, and t_{module} means a charging and discharging time of the waste battery in the module unit / the number of cells.

In one embodiment, the method may include electrically discharging a normal module satisfying Equation 1 to 0.1 V or less. In one embodiment, after the electrical discharging step, the method may include grounding the normal module.

In one embodiment, the method may include shredding the normal module on which the electrical discharge has been performed. In one embodiment, shredding the normal module may be performed in an inert gas.

In one embodiment, shredding the normal module may be performed in an atmosphere having an oxygen concentration of 3% or less. In one embodiment, after shredding the normal module, the method may include drying a shredded result at a temperature of 200°C or less. In one embodiment, the step of measuring charging and discharging rates of the waste battery to measure an average charging and discharging rate may perform charging and discharging of the waste battery at a constant voltage or a constant current.

A battery treatment method according to another embodiment of the present invention may include preparing a waste battery in a module unit including a plurality of cells, measuring charging and discharging rates of the waste battery, evaluating a temperature of each cell unit in the module, and determining whether a module is a normal module or a defective module according to whether a temperature deviation of each cell unit satisfies 3°C or less.

In one embodiment, the method may include electrically discharging the normal module to 0.1 V or less. In one embodiment, the method may include shredding the normal module on which the electrical discharge has been performed in an atmosphere having an oxygen concentration of 0.5% or less. In one embodiment, after shredding the normal module, the method may include drying a shredded result at a temperature of 200°C or less. In one embodiment, the method may include freeze-shredding the defective module.

A battery treatment method according to still another embodiment of the present invention may include preparing a waste battery in a pack unit including a plurality of modules or having two or more modules, measuring charging and discharging rates of the waste battery in the pack unit including the plurality of modules or having two or more modules to measure an average charging and discharging time, measuring charging and discharging rates of a waste battery in a module unit to measure a charging and discharging time of the waste battery in the module unit and comparing the same with the average charging and discharging time, determining whether the waste battery in the module unit is a normal module or a defective module, shredding the normal module or the defective module, and drying a shredded result at a temperature of 200°C or less, wherein the dried result may satisfy the following Equation 2. <Equation 2> $\frac{{w}_{2} - {w}_{1}}{{w}_{1}} \times 100 ≦ 10$

In Equation 2, w1 and w2 mean an initial weight (kg) of the shredded result and a weight (kg) of the dried result, respectively.

In one embodiment, the step of measuring charging and discharging rates in the module unit and comparing the same with the average charging and discharging rate to determine whether the module is a normal module or a defective module may include determining whether the following Equation 1 is satisfied. <Equation 1> $\frac{\left|{t}_{aver}-{t}_{module}\right|}{{t}_{aver}} \leq \frac{1}{number cell in module}$

In one embodiment, after measuring charging and discharging rates in the module unit and comparing the same with the average charging and discharging rate, the method may include electrically discharging a normal module satisfying Equation 1 to 0.1 V or less. In one embodiment, after measuring charging and discharging rates in the module unit and comparing the same with the average charging and discharging rate, freezing a defective module not satisfying Equation 1 may be performed at a temperature range of -20°C or lower.

### [Advantageous Effects]

A battery treatment method according to one embodiment of the present invention provides a battery treatment method capable of safely discharging a battery even when the battery includes a short-circuited cell, and reducing a risk of fire when shredding the discharged battery, by checking whether there is a short circuit in a cell unit through electrical discharge and safely performing a shredding process.

### [BRIEF DESCRIPTION OF THE DRAWINGS]

FIG. 1 is a view in which a temperature of a battery module itself of the present invention is measured with a thermal imaging camera.
FIGS. 2A and 2B are graphs of temperature rise before battery shredding and during battery shredding.

### [MODE FOR CARRYING OUT THE INVENTION]

Terms such as first, second, and third are used to describe various parts, components, regions, layers, and/or sections, but are not limited thereto. These terms are used only to distinguish one part, component, region, layer, or section from another part, component, region, layer, or section. Accordingly, a first part, component, region, layer, or section described below may be referred to as a second part, component, region, layer, or section without departing from the scope of the present invention.

The terminology used herein is merely for referring to particular embodiments and is not intended to limit the present invention. As used herein, singular forms also include plural forms unless the context clearly indicates otherwise. As used in the specification, the term "comprising" specifies stated features, regions, integers, steps, operations, elements, and/or components, and does not exclude the presence or addition of other features, regions, integers, steps, operations, elements, and/or components.

When a part is referred to as being "above" or "on" another part, it may be directly above or on the other part, or another part may be interposed therebetween. In contrast, when a part is referred to as being "directly above" another part, no other part is interposed therebetween.

Although not otherwise defined, all terms used herein, including technical and scientific terms, have the same meanings as commonly understood by a person having ordinary skill in the art to which the present invention pertains. Terms defined in commonly used dictionaries are further interpreted as having meanings consistent with the related technical literature and the presently disclosed content, and unless defined otherwise, are not interpreted in an idealized or overly formal sense.

Hereinafter, embodiments of the present invention will be described in detail. However, these are provided as examples, and the present invention is not limited thereto, and the present invention is only defined by the scope of the claims to be described below.

A battery treatment method according to one embodiment of the present invention may include preparing a waste battery in a module unit including a plurality of cells or a pack unit including a plurality of modules, and determining whether a module is a normal module or a defective module. Specifically, the battery treatment method of the present invention may be a battery treatment method for safely discharging a battery and reducing a fire risk during battery shredding by determining whether a module is a normal module or a defective module by measuring charging and discharging rates of a battery in a module unit or a pack unit.

The step of preparing a waste battery in a module unit including a plurality of cells, or in a pack unit including a plurality of modules or having two or more modules, may prepare a lithium secondary battery separated from a vehicle or a secondary battery separated from an electronic device such as a mobile phone, a camera, or a laptop computer, specifically a lithium secondary battery. The lithium secondary battery may be a battery in a module unit including a plurality of cells or a waste battery in a pack unit including a plurality of modules. The waste battery may include a normal module having a voltage of about 2.0 V to 4.5 V on a cell basis, and a defective module that is short-circuited and thus is not easy to measure the voltage.

In the step of preparing the waste battery, when the waste battery is a pack-unit waste battery including the plurality of modules or a waste battery having two or more modules, the method may include measuring charging and discharging rates of the waste battery to measure an average charging and discharging rate. Specifically, the step of measuring the charging and discharging rates of the waste battery to measure the average charging and discharging rate may be performed such that charging and discharging are uniformly performed using constant-voltage discharge/recharge or constant-current discharge/recharge. This may calculate an average charging and discharging time of a module by dividing the time taken for charging and discharging of the entire pack by the number of modules for the plurality of modules disposed in the pack.

After measuring charging and discharging rates of the waste battery in the pack unit including the plurality of modules or having two or more modules to measure the average charging and discharging rate, the pack-unit waste battery may be dismantled into module units. Specifically, this may be a pretreatment step for dismantling the pack-unit waste battery disposed in a plurality of module units and calculating charging and discharging rates of each module.

After dismantling the pack-unit waste battery into module units, the method includes measuring charging and discharging rates in a module unit to measure a charging and discharging time of the waste battery in the module unit, and comparing the same with the average charging and discharging time. Specifically, this may be a step of comparing the charging and discharging time of each of the plurality of waste batteries in the module unit with the average charging and discharging time of the waste battery in the pack unit.

It may be determined whether the average charging and discharging time of the waste battery in the pack unit including the plurality of modules or having two or more modules and the charging and discharging time of the waste battery in the module unit satisfy the following Equation 1. Specifically, when the average charging and discharging time of the waste battery in the pack unit including the plurality of modules or having two or more modules and the charging and discharging time of the waste battery in the module unit satisfy the following Equation 1, the module may be determined as a normal module, and when Equation 1 is not satisfied, a short-circuited module in which charging and discharging are not smoothly performed due to occurrence of a short circuit may be determined. <Equation 1> $\frac{\left|{t}_{aver}-{t}_{module}\right|}{{t}_{aver}} \leq \frac{1}{number cell in module}$

In Equation 1, tₐᵥₑᵣ means the average charging and discharging time of the waste battery in the pack unit including a plurality of modules or having two or more modules / the number of waste batteries in a module unit, and t_{module} means the charging and discharging time of the waste battery in the module unit / the number of cells.

Satisfying Equation 1 means that a value obtained by dividing a difference value between the average charging and discharging time of the pack-unit waste battery and the charging and discharging time of the module-unit waste battery by the average charging and discharging time of the pack-unit waste battery is smaller than a fraction of the number of cells in the module-unit waste battery, and this may be an index for determining that the module is a normal module. In contrast, not satisfying Equation 1 means that a value obtained by dividing the difference value between the average charging and discharging time of the pack-unit waste battery and the charging and discharging time of the module-unit waste battery by the average charging and discharging time of the pack-unit waste battery has a value greater than the fraction of the number of cells in the module-unit waste battery, and means that at least one cell in the module is defective due to a short circuit or the like.

As described above, the present invention can easily determine whether a module in a waste battery is normal or defective by measuring charging and discharging rates of the waste battery and calculating charging and discharging times therefrom.

In one embodiment, the method may include electrically discharging a normal module satisfying Equation 1 to 0.1 V or less. Specifically, the normal module satisfying Equation 1 is a module of which voltage can be lowered by electrical discharge, and the voltage of the module may be lowered to 0.1 V or less, specifically 0.8 V or less, and more specifically 0.5 V or less on a cell basis by performing electrical discharge. When the normal module is electrically discharged to the above-described range, a process can be safely performed in a subsequent step of pulverizing cells because no spark occurs and no smoke or fire occurs. In contrast, when outside the above-described range, a safety problem may be caused in performing the process.

In one embodiment, the method may include freezing a defective module not satisfying Equation 1. The defective module is a module including a problem such as a short circuit, and has a problem in that a voltage on a cell basis in the module cannot be lowered through electrical discharge. By freezing the defective module, the module can be easily discharged without generating wastewater, unlike brine discharge.

In one embodiment, the step of freezing the defective module may be performed at a temperature range of -20°C or lower. In one embodiment, the step of freezing the defective module is performed at a temperature sufficient to freeze an electrolyte included in the battery. Specifically, the step of freezing the defective module may be performed, for example, at a temperature range of -150°C to -20°C. More specifically, the temperature range may be -150°C to -50°C, and more specifically -80°C to -60°C.

When the defective module is frozen in the above temperature range, a voltage minutely remaining inside the battery, for example, a voltage of about 2 V to 3 V, decreases close to 0 V. Accordingly, even when a short circuit occurs in which a positive electrode and a negative electrode directly contact each other, a battery reaction does not occur, and thus the battery temperature does not increase, and gas generation and combustion of the electrolyte do not occur. In addition, since the electrolyte is in a frozen state or in a state in which vaporization is suppressed, mobility of lithium ions is very low, and conduction characteristics due to the movement of the lithium ions can be remarkably reduced, and since vaporization of the electrolyte solution does not occur, flammable gases of ethylene, propylene, and hydrogen may not be generated.

When the freezing process is outside the above temperature range, the voltage remaining inside the battery does not decrease to 0 V, and a battery reaction due to a short circuit may occur, and the electrolyte is not completely frozen, which is not appropriate. As described above, before shredding a battery such as a lithium secondary battery, the battery treatment method includes freezing a defective module, whereby there is an advantage in that a defective module for which electrical discharge is difficult can be easily discharged, thereby preventing a risk of fire that may occur in a battery shredding process.

In one embodiment, the step of freezing the defective module may be performed for 15 hours to 36 hours. The step of freezing the defective module may be performed for 20 hours to 30 hours, specifically 22 hours to 27 hours. By performing the step of freezing the defective module within the above time range, battery stabilization is easily performed, and when the battery is shredded, fire can be prevented from occurring from the battery.

When the step of freezing the defective module is performed for a time excessively longer than the above time, there is a problem in terms of economic feasibility. When the step of freezing the defective module is performed for a time excessively shorter than the above time, there is a problem in that battery stabilization is not easily performed.

In one embodiment, the battery treatment method may include, after the electrical discharging step, grounding the normal module. Specifically, a waste battery on which electrical discharge has been performed, for example, a (+) pole and a (-) pole of a module, may be grounded to continuously maintain a discharged state. By including the grounding step, it is possible to prevent voltage of the waste battery from being recovered due to a standard reduction potential difference. In one embodiment, the step of grounding the normal module may be performed for 6 hours or more. Specifically, the step of grounding the module may be performed for 8 hours or more.

In one embodiment, the battery treatment method may include shredding the normal module on which electrical discharge has been performed or the defective module on which the freezing step has been performed. Specifically, this may mean a process of applying impact or pressure to the battery so that a portion of the battery is separated from the battery, wherein the battery is the normal module on which electrical discharge has been performed or the defective module on which the freezing step has been performed. The step of shredding the normal or defective module may mean all of a process of pulverizing the battery, a process of cutting the battery, a process of compressing the battery, and a combination thereof. Specifically, the shredding step may include all processes capable of destroying the battery, which is the normal or defective module, to obtain shredded pieces having a small size.

In one embodiment, the step of shredding the normal or defective module may include all processes of compressing the battery, which is the normal or defective module, or destroying the battery by applying external force such as shear force or tensile force. The step of shredding the normal or defective module may be performed, for example, using a shredder.

In one embodiment, the step of shredding the normal or defective module may be performed at least once or more. Specifically, the shredding step may be performed continuously or discontinuously at least once or more.

In one embodiment, the step of shredding the normal or defective module may be performed under a condition of supplying an inert gas, carbon dioxide, nitrogen, water, or a combination thereof, or under a vacuum atmosphere condition of 100 torr or less. As the step of shredding the normal or defective module is performed under the above-described gas atmosphere, the process can be performed with safety compared with a case in which the process is performed in air.

In one embodiment, the step of shredding the normal or defective module may be performed in an atmosphere having an oxygen concentration of 3% or less. Specifically, the step of shredding the normal or defective module may have an oxygen concentration of 3% or less by volume, and more specifically 0.1% or less. In one embodiment, the step of shredding the normal or defective module may be performed within 6 hours.

As the oxygen concentration in the shredding step satisfies the above-described range, safety problems in the process can be solved. When the oxygen concentration is excessively high, if the oxygen concentration is 6% or more, there is a problem in that, when a spark occurs in the waste battery, the oxygen reacts with an electrolyte solution to cause fire.

In one embodiment, after the step of shredding the normal or defective module, the method may include drying a shredded result at a temperature of 200°C or less. The drying step may be a step for removing an electrolyte solution in the shredded result.

In one embodiment, hot air may be used in the drying step. Specifically, hot air using a gas may be applied to the shredded result to remove an electrolyte solution in the shredded result.

In one embodiment, the gas for hot air may be an inert gas. For example, the inert gas may be carbon dioxide, nitrogen, argon, helium, or a combination thereof. By using the inert gas as the gas for hot air, there is an advantage in terms of fire prevention.

In one embodiment, the drying step may be performed in an atmosphere having an oxygen concentration of 5% or less. As the oxygen concentration in the drying step satisfies the above-described range, the possibility of smoke or fire occurrence can be lowered. Specifically, voltage of a portion of cut battery shredded pieces may be recovered over time, and at this time, smoke may be generated as the voltage reacts with a partially volatilized electrolyte solution. At this time, by performing drying within the above-described oxygen concentration range, the possibility of smoke being generated from the battery shredded pieces can be remarkably lowered.

In one embodiment, the drying step may be performed within 6 hours, specifically within 4 hours. When the inert gas is used in the drying step, if the oxygen concentration is outside the above-described range, a problem in which safety is lowered in performing the process may be caused.

In one embodiment, the dried result that has undergone the drying step may satisfy the following Equation 2. <Equation 2> $\frac{{w}_{2} - {w}_{1}}{{w}_{1}} \times 100 ≦ 10$

In Equation 2, w1 and w2 mean an initial weight (kg) of the shredded result and a weight (kg) of the dried result, respectively.

Equation 2 means a weight change amount when the shredded result is dried, and may be an index for volatilization of the electrolyte solution. Equation 2 may satisfy 10% or less, specifically 2.0% to 8.0%, and more specifically 3.8% to 7.8%. As Equation 2 satisfies the above-described range, 40% or more of the electrolyte solution in the shredded result is volatilized, and thus a stabilized shredded product can be obtained. When Equation 2 is outside the above-described range, there is a problem in that safety becomes problematic or process efficiency decreases because the electrolyte solution cannot be easily removed.

A battery treatment method according to another embodiment of the present invention may provide a method for treating a battery in a module unit including a plurality of cells. The battery treatment method may include preparing a waste battery in a module unit including a plurality of cells, measuring charging and discharging rates of the waste battery, evaluating a temperature of each cell unit in the module, and determining whether a module is a normal module or a defective module according to whether a temperature deviation of each cell unit satisfies 3°C or less.

The step of measuring charging and discharging rates of the waste battery in the module unit including the plurality of cells may be performed by the same method as the method of measuring charging and discharging rates of a module-unit waste battery in the above-described battery treatment method for a pack-unit waste battery including a plurality of modules.

A normal module satisfying Equation 3 may include an electrical discharging step, a shredding step, and a drying step, as in the above-described method for treating a battery from a pack-unit waste battery. A defective module not satisfying Equation 3 may include a freezing step, a shredding step, and a drying step, as in the above-described method for treating a battery from a pack-unit waste battery, and a detailed description thereof may refer to the above description within a range that is not contradictory.

Hereinafter, preferred Examples and Comparative Examples of the present invention will be described. However, the following Examples are merely preferred embodiments of the present invention, and the present invention is not limited to the following Examples.

### <Experimental Example 1>: Method for Determining and Treating Normal Module in Battery Pack

### Battery Preparation Step

In the present invention, as the battery, a module including a plurality of cells and a battery pack including a plurality of the modules were prepared.

### Determination of Whether Short Circuit Exists in Battery

Charging and discharging were performed on the battery pack. At this time, during charging and discharging of the battery, charging and discharging were uniformly performed using constant-voltage discharge/recharge or constant-current discharge/recharge. In this case, when a plurality of modules are disposed in the pack, and the time taken for charging and discharging of the entire pack is divided by the number of modules, an average charging and discharging time of the modules is obtained. Thereafter, dismantling is performed in a module unit. After dismantling in a module unit, charging and discharging are performed in a module unit, and this is performed using the same value among constant-voltage discharge or constant-current discharge used in the pack.

At this time, when the number of modules in the pack is divided, an average charging and discharging time (taver) of the module is obtained. By comparing charging and discharging rates of the separated modules, when the charging and discharging rates of the separated modules differ by a predetermined time or more, a module in which a short circuit has occurred can be determined.

The average charging and discharging time (tₐᵥₑᵣ) and the predetermined time were calculated through the following relational expressions.

### <Average Charging and Discharging Time (tₐᵥₑᵣ)>

${t}_{aver} = pack average charge - discharge time / number of modules$

### <Predetermined Time>

$\frac{\left|{t}_{aver}-{t}_{module}\right|}{{t}_{aver}} \leq \frac{1}{number cell in module}$

Through the above equation, when a difference value between the average charging and discharging time of the pack and the average discharging time of the module is smaller than a fraction of the number of cells in the module, the module is determined as a normal module. In the above equation, when the difference value between the average charging and discharging time of the pack and the average discharging time of the module is greater than the fraction of the number of cells in the module, the possibility that at least one cell is defective due to a short circuit or the like increases, and thus the module is determined as a defective module.

### Electrical Discharge Performed on Normal Module

Electrical discharge was performed on a module determined to be normal because the average charging and discharging time and the predetermined time satisfied the above-described relational expression. In the electrical discharge, whether a spark occurred and whether smoke and fire occurred were measured while pulverizing cells according to voltages several times.

After discharge, the + pole and the - pole of the module were grounded so that discharge could be continuously maintained, and voltage recovery due to a standard reduction potential difference was prevented. At this time, grounding was performed for 6 hours or more.

Table 1 below shows whether a spark occurred and whether smoke and fire occurred according to voltage when electrical discharge was performed.

Whether a spark occurred and whether smoke and fire occurred were measured by the following methods.

Whether spark occurred: When temperature was measured using a thermal imaging camera, whether the temperature increased by 20°C or more was checked. When the temperature increased by 20°C or more, it was marked as ○ as a case in which a spark occurred. When the temperature increased between 10°C and 20°C, it was marked as △. When the temperature did not increase by more than 10°C, it was marked as × as a case in which no spark occurred.

Whether smoke and fire occurred: Whether smoke and fire occurred was visually checked while electrical discharge was performed, and a case in which smoke or fire occurred was marked as ○, and a case in which smoke or fire did not occur was marked as ×.

**[Table 1]**

| No. | Voltage During Discharge (V) | Spark Occurrence | Smoke Occurrence | Fire Occurrence | Remarks |
|---|---|---|---|---|---|
| Experimental Example | 4 | ○ | ○ | ○ | Comparative Example |
| Experimental Example | 3.5 | ○ | ○ | ○ | Comparative Example |
| Experimental Example | 3 | ○ | ○ | × | Comparative Example |
| Experimental Example | 2.5 | ○ | ○ | × | Comparative Example |
| Experimental Example | 2 | ○ | ○ | × | Comparative Example |
| Experimental Example | 1.5 | ○ | × | × | Comparative Example |
| Experimental Example | 1.0 | ○ | × | × | Comparative Example |
| Experimental Example | 0.8 | Δ | × | × | Example |
| Experimental Example | 0.5 | × | × | × | Example |
| Experimental Example | 0.2 | × | × | × | Example |
| Experimental Example | 0.1 | × | × | × | Example |

Referring to Table 1, it was confirmed that, when electrical discharge was performed at a voltage lower than 1.0 V on a cell basis in a module having a series-parallel structure, no spark occurred, and when electrical discharge was performed to a voltage lower than 2.0 V, no smoke occurred.

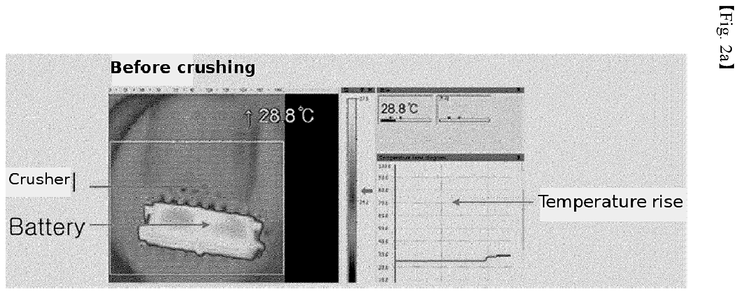

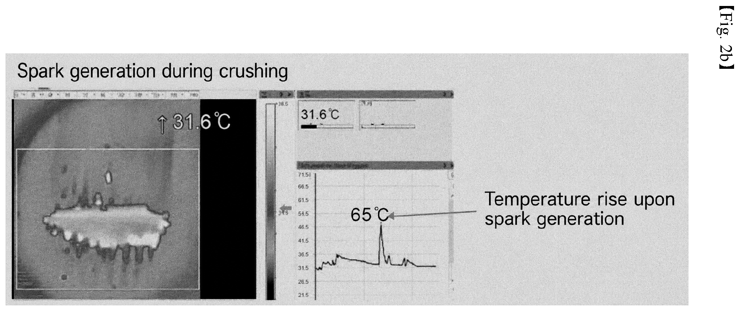

FIGS. 2A and 2B are graphs of temperature rise before battery shredding and during battery shredding.

FIG. 2A is a graph of temperature rise before shredding, and FIG. 2B is a graph of temperature rise during battery shredding. It was confirmed that no temperature rise occurred before battery shredding, and that a temperature rise peak occurred when a spark occurred during battery shredding.

### Battery Shredding

The battery was shredded using a shredder. At this time, since an additional fire may occur inside the shredder, nitrogen, argon, carbon dioxide, or the like, which is an inert gas, is introduced so that the oxygen amount is maintained at 1 wt% or less. In addition, since the shredded product maintains the structure of the battery even after being shredded, the size of the shredded product was controlled to be within 100 mm based on the major axis of the shredded product.

### Removal of Electrolyte Solution in Shredded Product

Hot air was supplied to the shredded product to remove an electrolyte solution in the shredded product. As the gas for the hot air, air was used or nitrogen (N₂) gas, which is an inert gas, was used. At this time, when the gas was air, the oxygen concentration was maintained at about 21%, and when the gas was an inert gas, the oxygen concentration was maintained at 5% or less. Thereafter, whether smoke occurred over time was determined. At this time, the temperature of the hot air was set to 120°C, and drying was performed for 12 hours.

Table 2 below shows whether smoke occurred according to air and inert gas conditions when hot air was supplied to the shredded product.

Whether smoke occurred: Whether smoke occurred from the shredded product was determined while the shredded product was placed on a rotatable table and slowly rotated at 10 rpm for 4 hours. A case in which smoke occurred was marked as ○, a case in which smoke did not occur but a burning smell or haze occurred was marked as △, and a state in which no smell or haze occurred at all, that is, a case in which smoke did not occur, was marked as ×.

**[Table 2]**

| Treatment Time | Smoke Occurrence | |
|---|---|---|
| | Inert Gas (Oxygen Content: 5% or Less) | Air (Oxygen Content: 21%) |
| 1 | × | × |
| 2 | × | × |
| 3 | × | ○ |
| 4 | × | ○ |
| 6 | △ | ○ |
| 8 | ○ | ○ |
| 12 | ○ | ○ |
| 16 | ○ | ○ |
| 20 | ○ | ○ |
| 24 | ○ | ○ |
| 48 | ○ | ○ |

Referring to Table 2, it was confirmed that, when hot air was applied to the shredded product, smoke did not occur when treatment was performed for 2 hours or less under air conditions, and smoke did not occur when treatment was performed for 6 hours or less under inert gas conditions, and thus there was no risk of fire.

### Weight Measurement Test of Shredded Product

Table 3 below shows weight changes of the shredded product over time when nitrogen gas was used as hot air in the step of drying the electrolyte solution and the temperature of the hot air was set to 120°C. The weight of the shredded product was measured by the following method.

Weight of shredded product: The weight of the shredded product was measured using a scale. The initial weight is the weight of the shredded product measured within 1 minute immediately after shredding in a step before drying, the weight after drying is the weight of the shredded product after the step of drying with hot air, and the weight change rate is a value obtained by converting a change rate of the weight after drying based on the initial weight of the shredded product.

**[Table 3]**

| Drying Time | Weight Measurement Test | | | Rotation Test | Remarks |
|---|---|---|---|---|---|
| | Initial Weight (kg) | Weight After Drying (kg) | Weight Change Rate (%) | Smoke Occurrence | |
| 20min | 1.01 | 0.99 | 2 | ○ | Comparative Example |
| 30min | 1.02 | 1.00 | 1.9 | ○ | Comparative Example |
| 1hour | 1.05 | 1.1 | 3.8 | × | Example |
| 1hour30min | 1.01 | 0.97 | 3.9 | × | Example |
| 2hour | 1.03 | 0.97 | 5.8 | × | Example |
| 3hour | 1.02 | 0.96 | 5.9 | × | Example |
| 4hour | 1.01 | 0.95 | 5.9 | × | Example |
| 6hour | 1.03 | 0.96 | 6.8 | × | Example |
| 12hour | 1.02 | 0.94 | 7.8 | × | Example |

Referring to Table 2, it was confirmed that smoke occurred from the shredded product when the weight change rate of the shredded product had a value of 2% or less. However, it was confirmed that smoke did not occur when the weight change rate of the shredded product satisfied 3% or more. The fact that about 6% of the shredded product changed in terms of weight may mean that the electrolyte solution was reduced by 40% or more because theoretically the entire electrolyte solution is included at a weight ratio of about 12% to 13%.

### <Experimental Example 2>: Method for Determining and Treating Defective Module in Battery Pack

Based on whether there was a short circuit in the battery in Experimental Example 1, a defective module was determined, and the defective module was subjected to a freezing step without separate electrical discharge. In the case of an internal short circuit, even when electrical discharge is performed, discharge is not performed, and thus detoxification was performed by freezing. Specifically, the defective module was subjected to cryogenic treatment at -60°C for 24 hours.

Thereafter, the battery subjected to cryogenic treatment was shredded using a general shredding apparatus, and the battery shredding step and subsequent drying step were performed in the same manner as in Experimental Example 1. During freeze-shredding, the freezing temperature varies depending on the charge amount of the waste battery. When the charge amount is 3 V or less on a cell basis, the freezing temperature is -50°C or less. When the charge amount is 3.5 V or less, the freezing temperature is -70°C or less. When the charge amount is 3.5 V or more, the freezing temperature is -90°C.

After shredding, storage without rotation is required in a stabilization system, and at this time, temperature rise due to self-heating proceeds. The shredding condition of the shredded product is preferably within 10 mm to 50 mm, and the average shredding size is most preferably 10 mm to 30 mm. If the size is larger, occurrence of fire increases, and if the size is smaller than 10 mm, there is difficulty in shredding because the shredded product is caught between shredder blades.

### <Experimental Example 3>: Method for Determining and Treating Battery Module Itself

In the battery preparation step of Experimental Example 1, a battery module including a plurality of cells, rather than a battery pack, was prepared. The battery module may form a parallel structure using two cells, or may also set a parallel structure with three to four cells. This varies depending on the module design of the battery. When the battery is charged and discharged, heat is generated due to movement of charge. In the case of a case visible from the outside, a short-circuited cell can be found using only a temperature deviation in a thermal imaging camera. During charging and discharging, the amount of heat generation increases based on 2.5 V according to the standard potential of a ternary battery. From 2.5 V or less, the amount of heat generation increases as the internal structure is deformed.

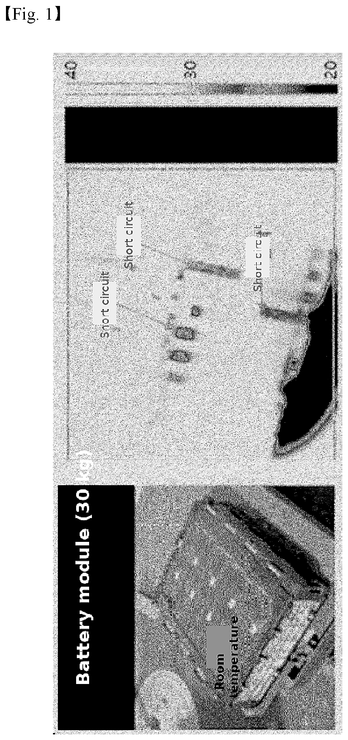

FIG. 1 is a view in which a temperature of a battery module itself of the present invention is measured with a thermal imaging camera.

Referring to FIG. 1, in the present invention, charging and discharging were separately distinguished, and during discharging, a temperature deviation between individual modules was measured through a thermal imaging camera in a state in which an external case was removed. The following figure shows a temperature deviation in the module, and when a short circuit occurs in a central portion, temperature rise appears slowly. It was confirmed that an internal short circuit existed when a temperature deviation of about 3°C or more occurred compared with the surroundings. It was confirmed that, in most normal cells, a temperature deviation occurred at 3°C or less.

Although preferred embodiments have been described in detail above, the scope of rights of the present invention is not limited thereto, and various modifications and improvements made by a person having ordinary skill in the art using the basic concept defined in the following claims also fall within the scope of rights of the present invention.

## Claims

1. A battery treatment method, comprising:
preparing a waste battery in a pack unit including a plurality of modules or having two or more modules;
measuring charging and discharging rates of the waste battery to measure an average charging and discharging time;
measuring charging and discharging rates of a module-unit waste battery in the waste battery to measure an average charging and discharging time of the module-unit waste battery and comparing the same with the average charging and discharging time; and
determining whether the module is a normal module or a defective module according to whether the average charging and discharging time of the waste battery in the pack unit including the plurality of modules or having two or more modules and the charging and discharging time of the module-unit waste battery satisfy the following Equation 1: <Equation 1> $\frac{\left|{t}_{aver}-{t}_{module}\right|}{{t}_{aver}} \leq \frac{1}{number cell in module}$
wherein, in Equation 1, tₐᵥₑᵣ means an average charging and discharging average time of the waste battery in a pack unit including a plurality of modules or having two or more modules / the number of module-unit waste batteries, and t_{module} means a charging and discharging time of the module-unit waste battery / the number of cells.

2. The battery treatment method of claim 1, further comprising electrically discharging a normal module satisfying Equation 1 to 0.1 V or less.

3. The battery treatment method of claim 2,
further comprising, after electrically discharging, grounding the normal module.

4. The battery treatment method of claim 2,
further comprising shredding the normal module on which the electrical discharge has been performed.

5. The battery treatment method of claim 4,
wherein shredding the normal module is performed in an inert gas.

6. The battery treatment method of claim 4,
wherein shredding the normal module is performed in an atmosphere having an oxygen concentration of 3% or less.

7. The battery treatment method of claim 3,
further comprising, after shredding the normal module,
drying a shredded result at a temperature of 200°C or less.

8. The battery treatment method of claim 7,
wherein drying is performed in an atmosphere having an oxygen concentration of 5% or less.

9. The battery treatment method of claim 1,
further comprising freezing the defective module.

10. The battery treatment method of claim 9,
wherein freezing the defective module is performed at a temperature range of -20°C or lower.

11. The battery treatment method of claim 1,
wherein measuring charging and discharging rates of the waste battery to measure the average charging and discharging rate comprises charging and discharging the waste battery at a constant voltage or a constant current.

12. A battery treatment method, comprising:
preparing a module-unit waste battery including a plurality of cells;
measuring charging and discharging rates of the waste battery;
evaluating a temperature of each cell unit in the module; and
determining whether the module is a normal module or a defective module according to whether a deviation of the temperature of each cell unit is 3°C or less.

13. The battery treatment method of claim 12,
further comprising electrically discharging the normal module to 0.1 V or less.

14. The battery treatment method of claim 13,
further comprising shredding the normal module on which the electrical discharge has been performed in an atmosphere having an oxygen concentration of 0.5% or less.

15. The battery treatment method of claim 14,
further comprising, after shredding the normal module,
drying a shredded result at a temperature of 200°C or less.

16. The battery treatment method of claim 12,
further comprising freeze-shredding the defective module.

17. A battery treatment method, comprising:
preparing a waste battery in a pack unit including a plurality of modules or having two or more modules;
measuring charging and discharging rates of the waste battery to measure an average charging and discharging time;
measuring charging and discharging rates of a module-unit waste battery in the waste battery in the pack unit including the plurality of modules or having two or more modules to measure a charging and discharging time of the module-unit waste battery and comparing the same with the average charging and discharging time;
determining whether the module-unit waste battery is a normal module or a defective module;
shredding the normal module or the defective module; and
drying a shredded result at a temperature of 200°C or less,
wherein the dried result satisfies the following Equation 2: <Equation 2> $\frac{{w}_{2} - {w}_{1}}{{w}_{1}} \times 100 ≦ 10$
wherein, in Equation 2, w1 and w2 mean an initial weight (kg) of the shredded result and a weight (kg) of the dried result, respectively.

18. The battery treatment method of claim 17,
wherein measuring charging and discharging rates in the module unit and comparing the same with the average charging and discharging rate to determine whether the module is a normal module or a defective module comprises determining whether the following Equation 1 is satisfied: <Equation 1> $\frac{\left|{t}_{aver}-{t}_{module}\right|}{{t}_{aver}} \leq \frac{1}{number cell in module}$

19. The battery treatment method of claim 18,
further comprising, after measuring charging and discharging rates in the module unit and comparing the same with the average charging and discharging rate,
electrically discharging a normal module satisfying Equation 1 to 0.1 V or less.

20. The battery treatment method of claim 17,
wherein, after measuring charging and discharging rates in the module unit and comparing the same with the average charging and discharging rate,
freezing a defective module not satisfying Equation 1 is performed at a temperature range of -20°C or lower.
